# EUROPEAN PATENT SPECIFICATION

(11) **EP 4 516 723 B1**
(45) Date of publication and mention of the grant of the patent: **31.12.2025**
(21) Application number: 24178198.8
(22) Date of filing: 27.05.2024
(51) Int. Cl.: B81B 3/00, G01C 19/5677, G01C 19/5684

(54) **SENSOR, SENSOR SYSTEM, AND ELECTRONIC DEVICE**
SENSOR, SENSORSYSTEM UND ELEKTRONISCHE VORRICHTUNG
CAPTEUR, SYSTÈME DE CAPTEUR ET DISPOSITIF ÉLECTRONIQUE

(30) Priority: 29.08.2023 JP 2023139067
(43) Date of publication of application: 05.03.2025
(73) Proprietor: KABUSHIKI KAISHA TOSHIBA, Minato-ku Tokyo 105-0023 (JP)
(72) Inventor: ONO, Daiki, Tokyo 105-0023 (JP); MURASE, Hideaki, Tokyo 105-0023 (JP); MIYAZAKI, Fumito, Tokyo 105-0023 (JP); TOMIZAWA, Yasushi, Tokyo 105-0023 (JP); MASUNISHI, Kei, Tokyo 105-0023 (JP); UCHIDA, Kengo, Tokyo 105-0023 (JP); OGAWA, Etsuji, Tokyo 105-0023 (JP); ISHIBASHI, Fumitaka, Tokyo 105-0023 (JP); OGAWA, Jumpei, Tokyo 105-0023 (JP)
(74) Representative: Hoffmann Eitle

(56) References cited:
- CN-A- 104 976 995
- US-B2- 7 493 814

## Description

### FIELD

Embodiments described herein relate generally to a sensor, a sensor system, and an electronic device.

### BACKGROUND

For example, there are sensors having a MEMS (Micro Electro Mechanical Systems) structure. In some cases, electronic devices and the like are controlled based on information obtained by sensors. It is desired to improve the characteristics of sensors. An example of the prior art can be seen in document CN 104 976 995 A which discloses a variable-resonance nested loop-type MEMS vibration gyro with the thick wall. The variable-resonance nested loop-type MEMS vibration gyro comprises a harmonic oscillator which comprises resonance rings, spoke-shaped supporting beams, and an anchor positioned at the center of the harmonic oscillator structure. The whole harmonic oscillator is fixedly anchored with a base by the anchor at the center of the harmonic oscillator and a plurality of resonance rings are nested at the periphery of the anchor by taking the anchor as the center. The spoke-shaped supporting beams are used for supporting every two adjacent resonance rings as well as between the innermost resonance ring and the anchor. The wall of the same resonance ring is same in thickness and the walls of the resonance rings from inside to outside are different in thickness. Document CN 104 976 995 A represents the closest prior art with reference to the claimed invention.

### BRIEF DESCRIPTION OF THE DRAWINGS

FIG. 1 is a schematic plan view illustrating a sensor according to a first embodiment;
FIG. 2 is a schematic plan view illustrating a part of the sensor according to the first embodiment;
FIG. 3 is a schematic cross-sectional view illustrating the sensor according to the first embodiment;
FIG. 4 is a schematic cross-sectional view illustrating the sensor according to the first embodiment;
FIG. 5 is a schematic cross-sectional view illustrating the sensor according to the first embodiment;
FIG. 6 is a schematic cross-sectional view illustrating the sensor according to the first embodiment;
FIG. 7 is a schematic plan view illustrating a part of the sensor according to the first embodiment;
FIG. 8 is a schematic plan view illustrating a sensor which does not form part of the invention.
FIG. 9 is a schematic plan view illustrating a sensor which does not form part of the invention.
FIG. 10 is a schematic plan view illustrating a sensor according to the first embodiment;
FIG. 11 is a schematic diagram illustrating an electronic device according to a second embodiment;
FIGS. 12A to 12H are schematic views illustrating applications of the electronic device according to the embodiment; and
FIGS. 13A and 13B are schematic views illustrating applications of the sensor according to the embodiment.

### DETAILED DESCRIPTION

According to one embodiment, a sensor includes a base including a first face, a fixed portion fixed to the first face, a movable portion supported by the fixed portion, a first fixed electrode fixed to the first face, and a first opposing fixed electrode fixed to the first face. A first gap is provided between the first face and the movable portion. The fixed portion includes a first center in a first plane parallel to the first face. The movable portion includes a first annular portion and a second annular portion. The first fixed electrode includes a first region and a second region. The first opposing fixed electrode includes a first opposing region and a second opposing region. The first region is provided between the second annular portion and the first annular portion. The first opposing region is provided between the second annular portion and the first region. The second region is provided between the second annular portion and the first annular portion. The second opposing region is provided between the second annular portion and the second region. A first region width of the first region in a radial direction, which is parallel to the first plane and passes through the first center, is different from a second region width of the second region in the radial direction. A first opposing region width of the first opposing region in the radial direction is different from a second opposing region width of the second opposing region in the radial direction. The movable portion includes a plurality of first connect portions extending along the radial direction, the plurality of first connect portions connect the first annular portion and the second annular portion, the first fixed electrode and the first opposing fixed electrode are provided between one of the plurality of first connect portions and another one of the plurality of first connect portions, and the other one of the plurality of first connect portions is next to the one of the plurality of first connect portions.

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously or illustrated in an antecedent drawing are marked with like reference numerals, and a detailed description is omitted as appropriate.

### (First Embodiment)

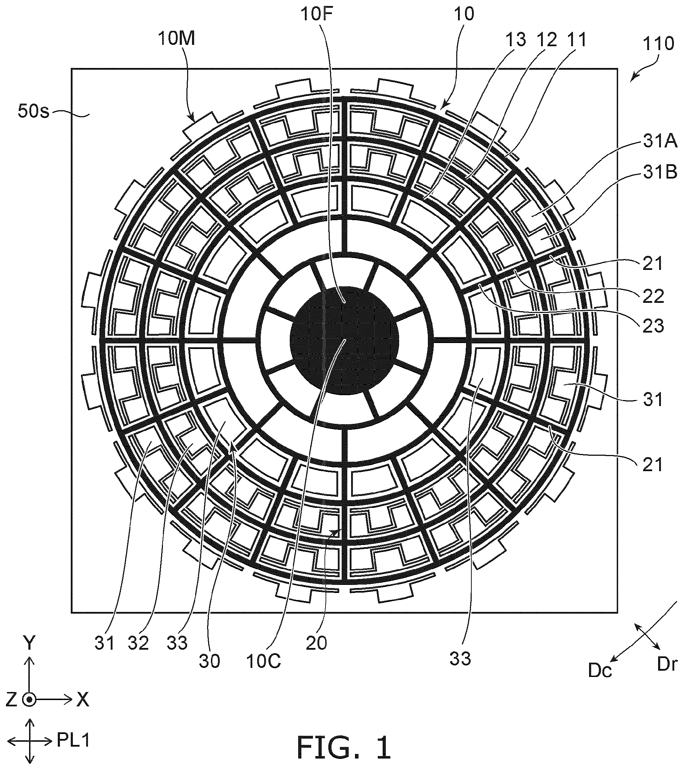

FIG. 1 is a schematic plan view illustrating a sensor according to a first embodiment.

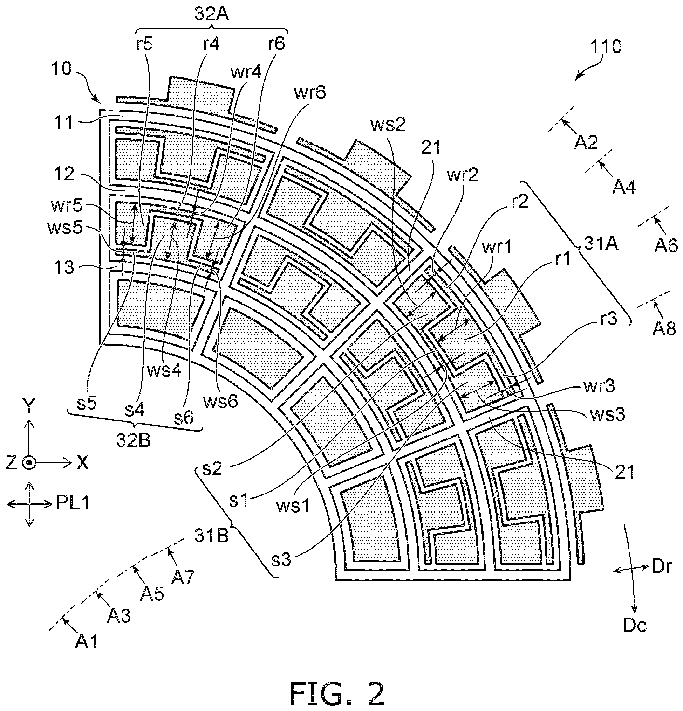

FIG. 2 is a schematic plan view illustrating a part of the sensor according to the first embodiment.

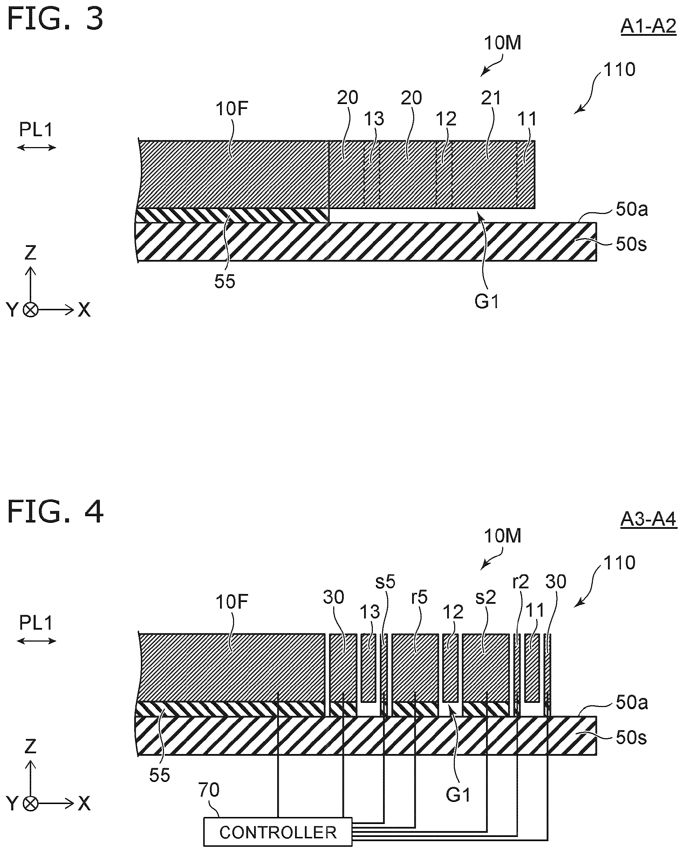

FIGS. 3 to 6 are schematic cross-sectional views illustrating the sensor according to the first embodiment.

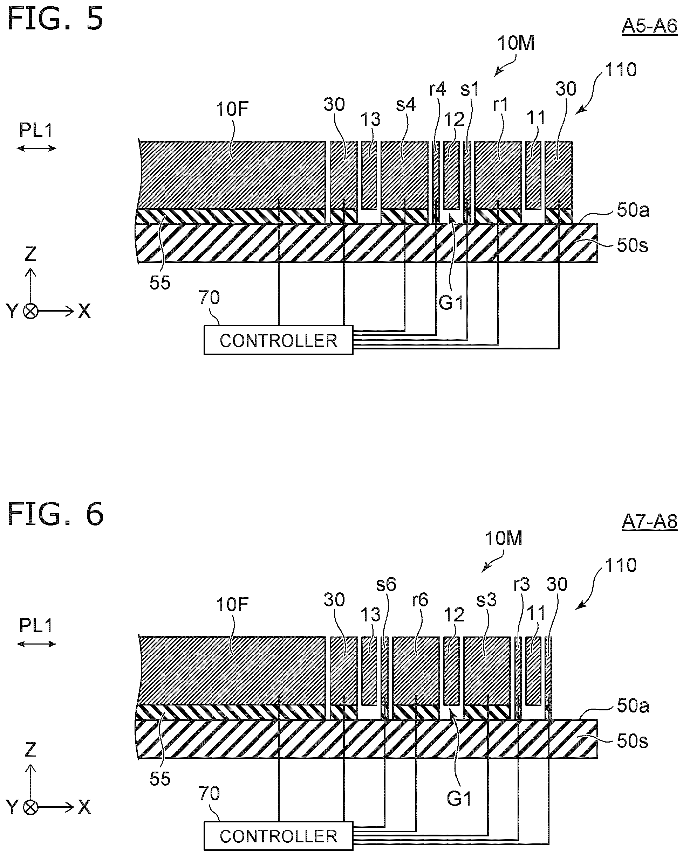

FIG. 3 is a sectional view taken along the line A1-A2 in FIG. 2. FIG. 4 is a sectional view taken along the line A3-A4 in FIG. 2. FIG. 5 is a sectional view taken along the line the A5-A6 in FIG. 2. FIG. 6 is a sectional view taken along the line A7-A8 in FIG. 2.

As shown in FIGS. 1 to 6, a sensor 110 according to the embodiment includes a base 50s, a fixed portion 10F, a movable portion 10M, a first fixed electrode 31A, and a first opposing fixed electrode 31B.

The base 50s includes a first face 50a. The fixed portion 10F is fixed to the first face 50a. The movable portion 10M is supported by the fixed portion 10F.

As shown in FIGS. 3 to 6, a first gap G1 is provided between the first face 50a and the movable portion 10M. For example, an insulating member 55 is provided on the first face 50a. The fixed portion 10F is provided on the insulating member 55. The insulating member 55 is not provided between the first face 50a and the movable portion 10M.

The movable portion 10M is electrically conductive. The movable portion 10M may include, for example, conductive silicon. The fixed portion 10F is electrically conductive. The fixed portion 10F may include, for example, conductive silicon. The fixed portion 10F is electrically connected to the movable portion 10M. The insulating member 55 may include, for example, silicon oxide.

As shown in FIG. 1, the fixed portion 10F includes a first center 10C in a first plane PL1 parallel to the first face 50a.

A direction perpendicular to the first plane PL1 is defined as a Z-axis direction. One direction perpendicular to the Z-axis direction is defined as an X-axis direction. A direction perpendicular to the Z-axis direction and the X-axis direction is defined as a Y-axis direction. The first plane PL1 is parallel to the X-Y plane.

The movable portion 10M includes a first annular portion 11 and a second annular portion 12. In this example, the second annular portion 12 is provided between the fixed portion 10F and the first annular portion 11. The first annular portion 11 may be provided between the fixed portion 10F and the second annular portion 12.

As shown in FIG. 2, the first fixed electrode 31A includes a first region r1 and a second region r2. The first opposing fixed electrode 31B includes a first opposing region s1 and a second opposing region s2. The first region r1 is provided between the second annular portion 12 and the first annular portion 11. The first opposing region s1 is provided between the second annular portion 12 and the first region r1. The second region r2 is provided between the second annular portion 12 and the first annular portion 11. The second opposing region s2 is provided between the second annular portion 12 and the second region r2.

As shown in FIG. 2, a width (length) of the first region r1 in a radial direction Dr parallel to the first plane PL1 and passing through the first center 10C is defined as a first region width wr1. a width (length) of the second region r2 in the radial direction Dr is defined as a second region width wr2. The first region width wr1 is different from the second region width wr2.

As shown in FIG. 2, a width (length) of the first opposing region s1 in the radial direction Dr is defined as a first opposing region width ws1. A width (length) of the second opposing region s2 in the radial direction Dr is defined as a second opposing region width ws2. The first opposing region width ws1 is different from the second opposing region width ws2.

In this example, the first region width wr1 is wider than the second region width wr2. The first opposing region width ws1 is narrower than the second opposing region width ws2.

For example, in the sensor 110, a plurality of fixed electrodes 30 are provided. For example, the plurality of fixed electrodes 30 are fixed to the first face 50a. The first fixed electrode 31A and the first opposing fixed electrode 31B are included in the plurality of fixed electrodes 30.

For example, a signal including an alternating component is applied between a part of the plurality of fixed electrodes 30 and the movable portion 10M. Thereby, the movable portion 10M vibrates. When an external force is applied to the movable portion 10M vibrating, the vibration state changes. By detecting a change in the vibration state, the applied external force can be detected. The change in the vibration state is detected as a change in capacitance, for example. The change in the vibration state due to external forces are caused by, for example, Coriolis force. The change in the vibration state can be detected, for example, by another part of the plurality of fixed electrodes 30. The signal may be supplied by the controller 70, for example. For example, the controller 70 may detect the change in the vibration state.

In the sensor 110, the first fixed electrode 31A faces the first annular portion 11. The first opposing fixed electrode 31B faces the second annular portion 12. By providing these electrodes in the narrow area between the second annular portion 12 and the first annular portion 11, the desired vibration can be obtained even when the size of the sensor 110 is reduced. The change in vibration state can be detected with high accuracy.

In the sensor 110, each of the first fixed electrode 31A and the first opposing fixed electrode 31B is provided with a wide region and a narrow region. For example, a connecting member (for example, a bonding wire) can be stably connected to the wide region. For example, even when the size of the sensor 110 is small, stable electrical connection can be obtained. For example, by stable electrical connection, highly accurate detection with suppressed noise can be obtained. According to the embodiment, a sensor with improved characteristics can be provided.

For example, the first region r1 and the second region r2 may be exchanged with each other. For example, in this case as well, a wide region and a narrow region are provided. For example, even when the size of the sensor 110 is small, stable electrical connection can be obtained. In the embodiment, the first annular portion 11 may be inside the second annular portion 12.

For example, in the sensor 110, one of a first condition and a second condition may be satisfied. In the first condition, the first region width wr1 is wider than the second region width wr2, and the first opposing region width ws1 is narrower than the second opposing region width ws2. In the second condition, the first region width wr1 is narrower than the second region width wr2, and the first opposing region width ws1 is wider than the second opposing region width ws2.

The second region r2 is continuous with the first region r1. The second opposing region s2 may be continuous with the first opposing region s1.

A direction from the second opposing region s2 to the first region r1 is along a circumferential direction Dc centered on the first center 10C. In the circumferential direction Dc, the second opposing region s2 faces the first region r1.

As shown in FIG. 2, the first fixed electrode 31A may further include a third region r3. The first opposing fixed electrode 31B may further include a third opposing region s3. The third region r3 is provided between the second annular portion 12 and the first annular portion 11. At least a part of the third opposing region s3 is provided between the second annular portion 12 and the third region r3. The first opposing region s1 is provided between the second opposing region s2 and the third opposing region s3. The first region width wr1 is different from a third region width wr3 of the third region r3 in the radial direction Dr. A first opposing region width ws1 is different from the third opposing region width ws3 of the third opposing region s3 in the radial direction Dr.

In this example, the first region width wr1 is wider than the second region width wr2. The first opposing region width ws1 is narrower than the second opposing region width ws2. The first region width wr1 is wider than the third region width wr3. The first opposing region width ws1 is narrower than the third opposing region width ws3.

The first region width wr1 may be narrower than the second region width wr2, and the first opposing region width ws1 may be wider than the second opposing region width ws2. In this case, the first region width wr1 is narrower than the third region width wr3, and the first opposing region width ws1 is wider than the third opposing region width ws3.

For example, in the circumferential direction Dc centered on the first center 10C, at least a part of the first region r1 is provided between the second region r2 and the third region r3. In the circumferential direction Dc, at least a part of the first opposing region s1 is provided between the second opposing region s2 and the third opposing region s3.

For example, a first ratio of a first absolute value of a difference between the first region width wr1 and the second region width wr2 to the first region width wr1 may be not less than 0.9 and not more than 30. A second ratio of a second absolute value of a difference between the first opposing region width ws1 and the second opposing region width ws2 to the first opposing region width ws1 may be not less than 0.9 and not more than 30.

The second region width wr2 may be not less than 0.05 times and not more than 30 the first region width wr1. The third region width wr3 may be not less than 0.8 times and not more than 1.2 times the second region width wr2.

The second opposing region width ws2 may be not less than 0.05 times and not more than 30 times the first opposing region width ws1. The third opposing region width ws3 may be not less than 0.8 times and not more than 1.2 times the second opposing region width ws2.

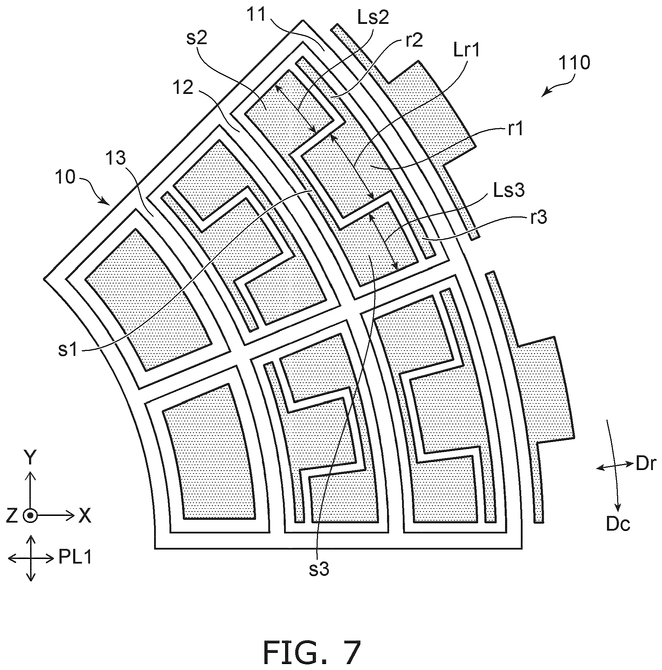

FIG. 7 is a schematic plan view illustrating a part of the sensor according to the first embodiment.

As shown in FIG. 7, in the sensor 110, a length of the second opposing region s2 in the circumferential direction Dc centered on the first center 10C is defined as a second opposing region length Ls2. A length of the third opposing region s3 in the circumferential direction Dc is defined as a third opposing region length Ls3. The second opposing region length Ls2 may be, for example, not less than 0.8 times and not more than 1.2 times the third opposing region length Ls3. For example, the second opposing region length Ls2 may be substantially the same as the third opposing region length Ls3, for example. Good symmetrical vibration can be obtained. For example, noise is suppressed. Highly accurate detection becomes easy.

A length of the first region r1 in the circumferential direction Dc is defined as a first region length Lr1. The first region length Lr1 may be, for example, not less than 0.1 times and not more than 10 times the second opposing region length Ls2. The first region length Lr1 may be, for example, not less than 0.8 times and not more than 1.2 times the second opposing region length Ls2.

As shown in FIG. 2, the movable portion 10M may include a plurality of first connect portions 21. The plurality of first connect portions 21 extend along the radial direction Dr. The plurality of first connect portions 21 connect the first annular portion 11 and the second annular portion 12. The first fixed electrode 31A and the first opposing fixed electrode 31B are provided between one of the plurality of first connect portions 21 and another one of the plurality of first connect portions 21. The other one of the plurality of first connect portions 21 is next to the one of the plurality of first connect portions 21 in the circumferential direction Dc.

As shown in FIG. 2, the sensor 110 may further include a second fixed electrode 32A and a second opposing fixed electrode 32B. The movable portion 10M may further include a third annular portion 13. The second annular portion 12 is provided between the third annular portion 13 and the first annular portion 11. In this example, the third annular portion 13 is provided between the fixed portion 10F and the second annular portion 12.

As shown in FIG. 2, the second fixed electrode 32A includes a fourth region r4 and a fifth region r5. The second opposing fixed electrode 32B includes a fourth opposing region s4 and a fifth opposing region s5. The fourth region r4 is provided between the third annular portion 13 and the second annular portion 12. The fourth opposing region s4 is provided between the third annular portion 13 and the fourth region r4. The fifth region r5 is provided between the third annular portion 13 and the second annular portion 12. The fifth opposing region s5 is provided between the third annular portion 13 and the fifth region r5.

A fourth region width wr4 of the fourth region r4 in the radial direction Dr is different from a fifth region width wr5 of the fifth region r5 in the radial direction Dr. A fourth opposing region width ws4 of the fourth opposing region s4 in the radial direction Dr is different from a fifth opposing region width ws5 of the fifth opposing region s5 in the radial direction Dr.

In each of the second fixed electrode 32A and the second opposing fixed electrode 32B, a wide region and a narrow region are provided. Electrical connections become easier. Noise is suppressed and highly accurate detection becomes possible.

In this example, the first region width wr1 is wider than the second region width wr2. The first opposing region width ws1 is narrower than the second opposing region width ws2. The fourth region width wr4 is narrower than the fifth region width wr5. The fourth opposing region width ws4 is wider than the fifth opposing region width ws5.

As shown in FIG. 2, the second fixed electrode 32A may further include a sixth region r6. The second opposing fixed electrode 32B may further include a sixth opposing region s6. The sixth region r6 is provided between the third annular portion 13 and the second annular portion 12. At least a part of the sixth opposing region s6 is provided between the third annular portion 13 and the sixth region r6. At least a part of the fourth region r4 is provided between the fifth region r5 and the sixth region r6.

The fourth region width wr4 is different from a sixth region width wr6 of the sixth region r6 in the radial direction Dr. The fourth opposing region width ws4 is different from a sixth opposing region width ws6 of the sixth opposing region s6 in the radial direction Dr.

In this example, the first region width wr1 is wider than the second region width wr2. The first opposing region width ws1 is narrower than the second opposing region width ws2. The fourth region width wr4 is narrower than the fifth region width wr5. The fourth opposing region width ws4 is wider than the fifth opposing region width ws5. The fourth region width wr4 is narrower than the fifth region width wr5. The fourth opposing region width ws4 is wider than the fifth opposing region width ws5. The fourth region width wr4 is narrower than the sixth region width wr6. The fourth opposing region width ws4 is wider than the sixth opposing region width ws6.

For example, the fifth region r5 is provided between the fifth opposing region s5 and the second region r2. For example, the second opposing region s2 is provided between the fifth region r5 and the second region r2.

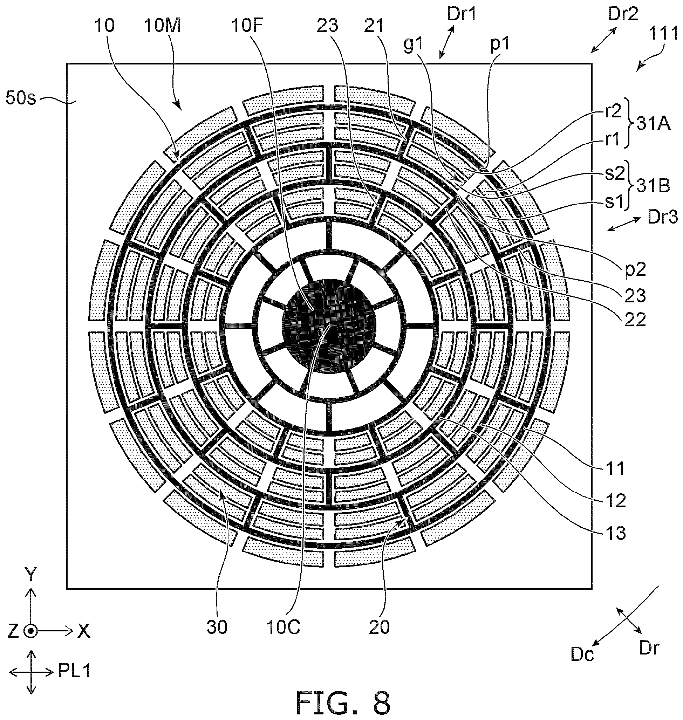

FIG. 8 is a schematic plan view illustrating a sensor which does not form part of the invention.

As shown in FIG. 8, in a sensor 111, the configurations of the first fixed electrode 31A and the first opposing fixed electrode 31B are different from the configuration in the sensor 110. The configuration of the sensor 111 except for this may be the same as the configuration of the sensor 110.

The sensor 111 also includes the base 50s, the fixed portion 10F, the movable portion 10M, the first fixed electrode 31A, and the first opposing fixed electrode 31B. The first gap G1 is provided between the first face 50a of the base 50s and the movable portion 10M (see FIGS. 3 to 6). As shown in FIG. 8, the fixed portion 10F includes the first center 10C in the first plane PL1 parallel to the first face 50a.

The movable portion 10M includes the plurality of annular portions 10 and the plurality of connect portions 20. The plurality of annular portions 10 are provided around the fixed portion 10F with the first center 10C as the center. The plurality of annular portions 10 include the first annular portion 11 , the second annular portion 12 , and the third annular portion 13. The second annular portion 12 is provided between the fixed portion 10F and the first annular portion 11. The third annular portion 13 is provided between the fixed portion 10F and the second annular portion 12.

The plurality of connect portions 20 include the first connect portion 21, a second connect portion 22, and a third connect portion 23. The first connect portion 21 is provided between the second annular portion 12 and the first annular portion 11 and connects the second annular portion 12 and the first annular portion 11. The first connect portion 21 is along a first radial direction Dr1. The first radial direction Dr1 passes through the first center 10C and is along the first plane PL1. The second connect portion 22 is provided between the third annular portion 13 and the second annular portion 12 and connects the third annular portion 13 and the second annular portion 12. The second connect portion 22 is along a second radial direction Dr2. The second radial direction Dr2 passes through the first center 10C and is along the first plane PL1. The third connect portion 23 is provided between the second annular portion 12 and the first annular portion 11 and connects the second annular portion 12 and the first annular portion 11. The third connect portion 23 is along a third radial direction Dr3. The third radial direction Dr3 passes through the first center 10C and is along the first plane PL1.

The second radial direction Dr2 crosses the first radial direction Dr1. The third radial direction Dr3 crosses the first radial direction Dr1 and the second radial direction Dr2. An angle (first angle) between the second radial direction Dr2 and the first radial direction Dr1 is smaller than an angle (second angle) between the third radial direction Dr3 and the first radial direction Dr1. In this example, the first angle is substantially 1/2 of the second angle.

The first fixed electrode 31A includes the first region r1 and the second region r2. The first opposing fixed electrode 31B includes the first opposing region s1 and the second opposing region s2. The first region r1 is provided between the second annular portion 12 and the first annular portion 11. The first opposing region s1 is provided between the second annular portion 12 and the first region r1. The second region r2 is provided between the second annular portion 12 and the first annular portion 11. The second opposing region s2 is provided between the second annular portion 12 and the second region r2.

The first annular portion 11 includes a first cross position p1 that crosses the second radial direction Dr2. The second annular portion 12 includes a second cross position p2 that crosses the second radial direction Dr2. A first radial gap g1 is provided between the first cross position p1 and the second cross position p2, between the first region r1 and the second region r2, and between the first opposing region s1 and the second opposing region s2.

In the sensor 111, four independent electrode regions (first region r1, second region r2, first opposing region s1, and second opposing region s2) are provided in a region surrounded by the first connect portion 21, the third connect portion 23, the second annular portion 12 and the first annular portion 11. By these electrode regions, desired vibration in the second annular portion 12 and the first annular portion 11 can be obtained. Alternatively, the vibration state of the second annular portion 12 and the first annular portion 11 can be accurately detected. By using four independent electrode regions, for example, noise can be suppressed. High precision detection is possible. A sensor capable of improving characteristics can be provided. For example, the influence of noise included in the electrical signal applied to the fixed electrodes 30 can be suppressed.

The first region r1 and the second region r2 are on one circumferential direction Dc. The first opposing region s1 and the second opposing region s2 are on one circumferential direction Dc. The first opposing region s1 and the first region r1 are on one radial direction Dr. The second opposing region s2 and the second region r2 are on one radial direction Dr. These four independent electrode regions form one set. A plurality of sets may be arranged along the circumferential direction Dc. The first region r1, the second region r2, the first opposing region s1, and the second opposing region s2 have an arc shape extending along the circumferential direction Dc.

In the sensor 111, the connect portion 20 is not provided between the first cross position p1 and the second cross position p2. The movable portion 10M has high flexibility. Vibration can be effectively generated.

In the sensor 111, the plurality of connect portions 20 extend along the radial direction Dr.

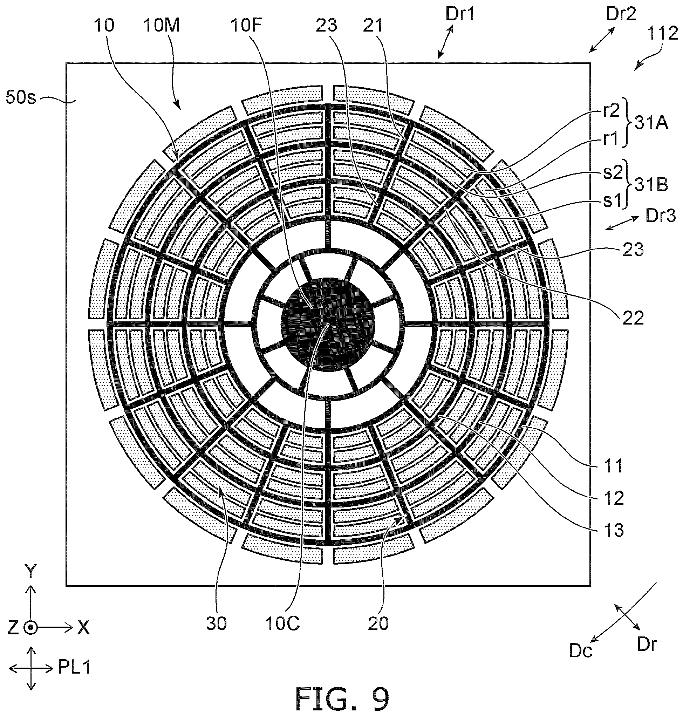

FIG. 9 is a schematic plan view illustrating a sensor which does not form part of the invention.

As shown in FIG. 9, in a sensor 112, the configurations of the first fixed electrode 31A and the first opposing fixed electrode 31B are different from the configuration in the sensor 110. The configuration of the sensor 112 except for this may be the same as the configuration of the sensor 110.

The sensor 112 also includes the base 50s, the fixed portion 10F, the movable portion 10M, the first fixed electrode 31A, and the first opposing fixed electrode 31B. The first gap G1 is provided between the first face 50a of the base 50s and the movable portion 10M (see FIGS. 3 to 6). As shown in FIG. 9, the fixed portion 10F includes the first center 10C in the first plane PL1 parallel to the first face 50a.

In the sensor 112, the movable portion 10M includes the plurality of annular portions 10 and the plurality of connect portions 20. The plurality of annular portions 10 are provided around the fixed portion 10F with the first center 10C as the center. The plurality of annular portions 10 include the first annular portion 11, the second annular portion 12 , and the third annular portion 13. The second annular portion 12 is provided between the fixed portion 10F and the first annular portion 11. The third annular portion 13 is provided between the fixed portion 10F and the second annular portion 12. The second annular portion 12 is next to the first annular portion 11. The third annular portion 13 is next to the second annular portion 12.

The plurality of connect portions 20 include the first connect portion 21 and the second connect portion 22. The first connect portion 21 and the second connect portion 22 are provided between the third annular portion 13 and the first annular portion 11. The first connect portion 21 and the second connect portion 22 connect the third annular portion 13, the second annular portion 12, and the first annular portion 11.

The first connect portion 21 is along the first radial direction Dr1. The first radial direction Dr1 passes through the first center 10C and is along the first plane PL1. The second connect portion 22 is along the second radial direction Dr2. The second radial direction Dr2 passes through the first center 10C and is along the first plane PL1. The second radial direction Dr2 crosses the first radial direction Dr1. For example, the second radial direction Dr2 is inclined with respect to the first radial direction Dr1.

The first fixed electrode 31A includes the first region r1 and the second region r2. The first opposing fixed electrode 31B includes the first opposing region s1 and the second opposing region s2. The first region r1 is provided between the second annular portion 12 and the first annular portion 11. The first opposing region s1 is provided between the second annular portion 12 and the first region r1. The second region r2 is provided between the second annular portion 12 and the first annular portion 11. The second opposing region s2 is provided between the second annular portion 12 and the second region r2. The second connect portion 22 passes between the first region r1 and the second region r2 and between the first opposing region s1 and the second opposing region s2.

In the sensor 112, three of the annular portions 10 are continuously connected by the first connect portion 21. The three of the annular portions 10 are continuously connected by the second connect portion 22. For example, it is easy to obtain a high intensity signal. By a high strength signal, noise is suppressed. In the sensor 112 as well, a sensor with improved characteristics can be provided.

The first region r1, the second region r2, the first opposing region s1, and the second opposing region s2 have an arc shape extending along the circumferential direction Dc.

In the sensor 112, the plurality of connect portions 20 may further include the third connect portion 23. The third connect portion 23 is provided between the third annular portion 13 and the first annular portion 11 and connects the third annular portion 13, the second annular portion 12, and the first annular portion 11. The third connect portion 23 is along the third radial direction Dr3. The third radial direction Dr3 passes through the first center 10C and extends along the first plane PL1. The third radial direction Dr3 crosses the first radial direction Dr1 and the second radial direction Dr2. The angle (first angle) between the second radial direction Dr2 and the first radial direction Dr1 is smaller than the angle (second angle) between the third radial direction Dr3 and the first radial direction Dr1. In this example, the first angle is substantially 1/2 of the second angle.

In the circumferential direction Dc, the first region r1 and the first opposing region s1 are provided between the first connect portion 21 and the second connect portion 22. The second region r2 and the second opposing region s2 are provided between the second connect portion 22 and the third connect portion 23.

In the sensor 112, the first region r1 and the second region r2 are on one circumferential direction Dc. The first opposing region s1 and the second opposing region s2 are on one circumferential direction Dc. The first opposing region s1 and the first region r1 are on one radial direction Dr. The second opposing region s2 and the second region r2 are on one radial direction Dr. These four independent electrode regions form one set. A plurality of sets may be arranged along the circumferential direction Dc.

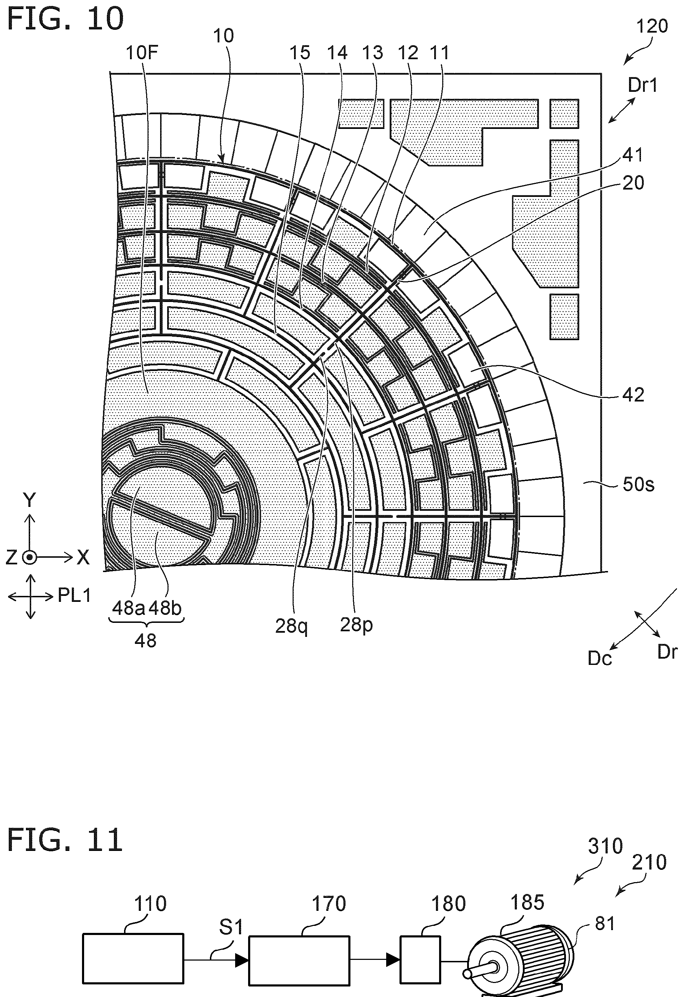

FIG. 10 is a schematic plan view illustrating a sensor according to the first embodiment.

FIG. 10 illustrates the fixed portion 10F and the movable portion 10M. In a sensor 120 according to the embodiment, the movable portion 10M includes the first structure 41. For example, the first structure 41 is connected to the first annular portion 11. The first annular portion 11 is provided between the fixed portion 10F and the first structure 41. The first structure 41 functions as a mass body, for example. It becomes easier to obtain stable vibrations. For example, noise can be suppressed.

The movable portion 10M may include the second structure 42. The second structure 42 is provided between the fixed portion 10F and the first annular portion 11. The second structure 42 is connected to the first annular portion 11, for example. The second structure 42 may be connected to one of the plurality of connect portions 20. The second structure 42 functions as a mass body, for example. Noise is suppressed.

As shown in FIG. 10, the movable portion 10M may further include a first radial structure 28p. The first radial structure 28p is connected to one of the plurality of annular portions 10. In this example, the first radial structure 28p is connected to the fourth annular portion 14. The first radial structure 28p extends from the one of the plurality of annular portions 10 along the first radial direction Dr1. The first radial structure 28p is separated from another one of the plurality of annular portions 10 in the first radial direction Dr1. In this example, the first radial structure 28p is separated from a fifth annular portion 15 in the first radial direction Dr1. The other one of the plurality of annular portions 10 is next to the one of the plurality of annular portions 10 among the plurality of annular portions 10. The other one of the plurality of annular portions 10 is closest to the one of the plurality of annular portions 10 among the plurality of annular portions 10.

The movable portion 10M may further include a second radial structure 28q. The second radial structure 28q is connected to the one of the plurality of annular portions 10. The second radial structure 28q is connected to the fifth annular portion 15. The second radial structure 28q extends from the other one of the plurality of annular portions 10 toward the one of the plurality of annular portions 10 along the first radial direction Dr1. The second radial structure 28q extends from the fifth annular portion 15 toward the fourth annular portion 14 along the first radial direction Dr1. The second radial structure 28q is separated from the first radial structure 28p in the first radial direction Dr1.

By providing such a radial structure, the overall mass distribution can be made uniform without connect portions for the plurality of annular portions 10 being adjacent. It becomes easier to obtain higher characteristics. For example, the movable portion 10M can vibrate with an appropriate degree of freedom. Vibration with a stable state can be obtained. The signal strength based on the vibration becomes high. Highly sensitive detection becomes possible.

As shown in FIG. 10, the sensor 120 may include an inner structure 48. The inner structure 48 is fixed to the first face 50a. The fixed portion 10F is provided around the inner structure 48. Electrical connections may be made via the inner structure 48. In this example, the inner structure 48 includes a first inner structure 48a and a second inner structure 48b. The inner structure 48 (for example, the first inner structure 48a and the second inner structure 48b) may be electrically insulated from the fixed portion 10F and the movable portion 10M. At least a part of the inner structure 48 (for example, the first inner structure 48a and the second inner structure 48b, etc.) is electrically connected to the fixed portion 10F or the movable portion 10M maybe connected by wiring for electrical connection.

In the sensor 120, the plurality of annular portions 10 include the first annular portion 11, the second annular portion 12, the third annular portion 13, the fourth annular portion 14, and the fifth annular portion 15. The number of the plurality of annular portions 10 is arbitrary.

### (Second Embodiment)

A second embodiment relates to an electronic device.

FIG. 11 is a schematic diagram illustrating an electronic device according to a second embodiment.

As shown in FIG. 11, an electronic device 310 according to the embodiment includes the sensors according to the first embodiment and the circuit processor 170. In the example of FIG. 11, the sensor 110 is drawn as the sensor. The circuit processor 170 is configured to control a circuit 180 based on the signal S1 obtained from the sensor. The circuit 180 is, for example, a control circuit for a drive device 185. According to the embodiment, for example, the circuit 180 for controlling the drive device 185 can be controlled with high accuracy.

As shown in FIG. 11, the sensor system 210 according to the embodiment includes the sensor (for example, the sensor 110) according to the first embodiment and a detection target member 81. The sensor 110 is fixed to the detection target member 81. The sensor 110 can detect a signal from the detection target member 81.

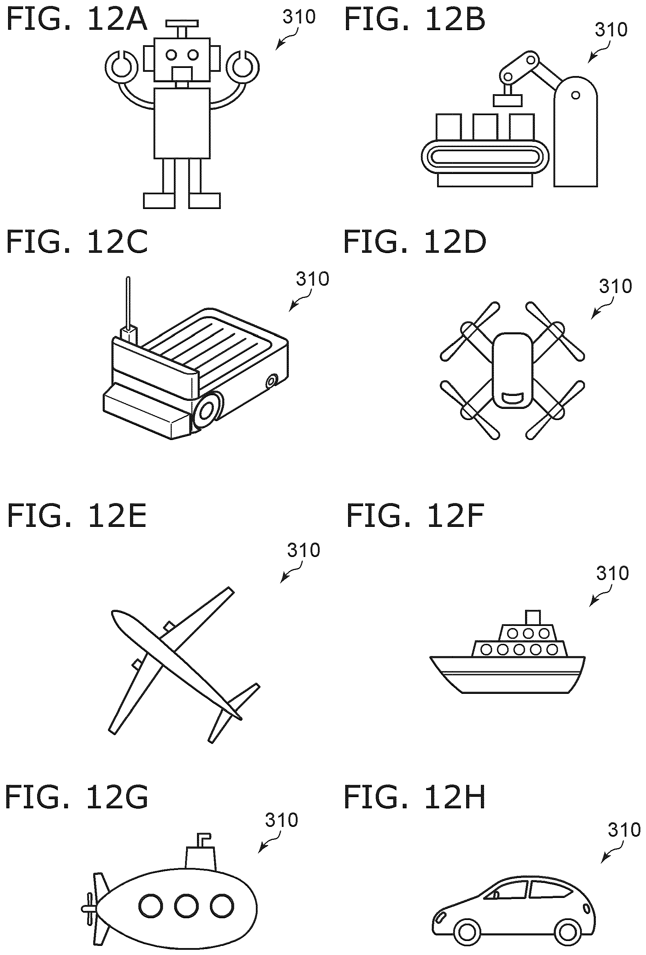

FIGS. 12A to 12H are schematic views illustrating applications of the electronic device according to the embodiment.

As shown in FIG. 12A, the electronic device 310 may be at least a portion of a robot. As shown in FIG. 12B, the electronic device 310 may be at least a portion of a machining robot provided in a manufacturing plant, etc. As shown in FIG. 12C, the electronic device 310 may be at least a portion of an automatic guided vehicle inside a plant, etc. As shown in FIG. 12D, the electronic device 310 may be at least a portion of a drone (an unmanned aircraft). As shown in FIG. 12E, the electronic device 310 may be at least a portion of an airplane. As shown in FIG. 12F, the electronic device 310 may be at least a portion of a ship. As shown in FIG. 12G, the electronic device 310 may be at least a portion of a submarine. As shown in FIG. 12H, the electronic device 310 may be at least a portion of an automobile. The electronic device 310 may include, for example, at least one of a robot or a moving body.

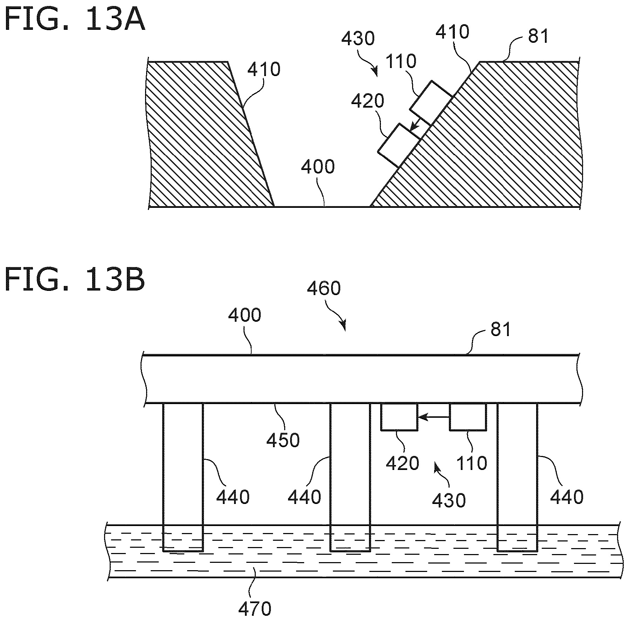

FIGS. 13A and 13B are schematic views illustrating applications of the sensor according to the embodiment.

As shown in FIG. 13A, a sensor 430 includes the sensor according to the first embodiment and a transmission/reception part 420. In the example of FIG. 13A, the sensor 110 is illustrated as the sensor. The transmission/reception part 420 is configured to transmit the signal obtained from the sensor 110 by, for example, at least one of wireless and wired methods. The sensor 430 is provided on, for example, a slope surface 410 such as a road 400. The sensor 430 can monitor the state of, for example, a facility (e.g., infrastructure). The sensor 430 may be, for example, a state monitoring device.

For example, the sensor 430 detects a change in the state of a slope surface 410 of a road 400 with high accuracy. The change in the state of the slope surface 410 includes, for example, at least one of a change in the inclination angle and a change in the vibration state. The signal (inspection result) obtained from the sensor 110 is transmitted by the transmission/reception part 420. The status of a facility (e.g., infrastructure) can be monitored, for example, continuously.

As shown in FIG. 13B, the sensor 430 is provided, for example, in a portion of a bridge 460. The bridge 460 is provided above the river 470. For example, the bridge 460 includes at least one of a main girder 450 and a pier 440. The sensor 430 is provided on at least one of the main girder 450 and the pier 440. For example, at least one of the angles of the main girder 450 and the pier 440 may change due to deterioration or the like. For example, the vibration state may change in at least one of the main girder 450 and the pier 440. The sensor 430 detects these changes with high accuracy. The detection result can be transmitted to an arbitrary place by the transmission/reception part 420. Abnormalities can be detected effectively.

According to the embodiment, a sensor, a sensor system, and an electronic device whose characteristics can be improved can be provided.

In the specification of the application, "perpendicular" and "parallel" refer to not only strictly perpendicular and strictly parallel but also include, for example, the fluctuation due to manufacturing processes, etc. It is sufficient to be substantially perpendicular and substantially parallel.

## Claims

1. A sensor (110), comprising:
a base (50s) including a first face (50a);
a fixed portion (10F) fixed to the first face (50a);
a movable portion (10M) supported by the fixed portion (10F);
a first fixed electrode (31A) fixed to the first face (50a); and
a first opposing fixed electrode (31B) fixed to the first face (50a),
a first gap (G1) being provided between the first face (50a) and the movable portion (10M),
the fixed portion (10F) including a first center (10C) in a first plane (PL1) parallel to the first face (50a),
the movable portion (10M) including a first annular portion (11) and a second annular portion (12),
wherein the movable portion (10M) includes a plurality of first connect portions (21) extending along the radial direction,
the plurality of first connect portions (21) connect the first annular portion (11) and the second annular portion (12),
the first fixed electrode (31A) and the first opposing fixed electrode (31B) are provided between one of the plurality of first connect portions (21) and another one of the plurality of first connect portions (21), and
the other one of the plurality of first connect portions (21) is next to the one of the plurality of first connect portions (21), and
**characterised by**
the first fixed electrode (31A) including a first region (r1) and a second region (r2),
the first opposing fixed electrode (31B) including a first opposing region (s1) and a second opposing region (s2),
the first region (r1) being provided between the second annular portion (12) and the first annular portion (11),
the first opposing region (s1) being provided between the second annular portion (12) and the first region (r1),
the second region (r2) being provided between the second annular portion (12) and the first annular portion (11),
the second opposing region (s2) being provided between the second annular portion (12) and the second region (r2),
a first region width (wr1) of the first region (r1) in a radial direction being different from a second region width (wr2) of the second region (r2) in the radial direction, the radial direction being parallel to the first plane (PL1) and passing through the first center (10C), and
a first opposing region width (ws1) of the first opposing region (s1) in the radial direction being different from a second opposing region width (ws2) of the second opposing region (s2) in the radial direction;

2. The sensor (110) according to claim 1, wherein
one of a first condition and a second condition is satisfied,
in the first condition, the first region width (wr1) is wider than the second region width (wr2), and the first opposing region width (ws1) is narrower than the second opposing region width (ws2), and
in the second condition, the first region width (wr1) is narrower than the second region width (wr2), and the first opposing region width (ws1) is wider than the second opposing region width (ws2).

3. The sensor (110) according to claim 1 or 2, wherein
the second region (r2) is continuous with the first region (r1), and
the second opposing region (s2) is continuous with the first opposing region (s1).

4. The sensor (110) according to any one of claims 1-3, wherein
a direction from the second opposing region (s2) to the first region (r1) is along a circumferential direction centered on the first center (10C).

5. The sensor (110) according to claim 1, wherein
the first fixed electrode (31A) further includes a third region (r3),
the first opposing fixed electrode (31B) further includes a third opposing region (s3),
the third region (r3) is provided between the second annular portion (12) and the first annular portion (11),
at least a part of the third opposing region (s3) is provided between the second annular portion (12) and the third region (r3),
the first opposing region (s1) is provided between the second opposing region (s2) and the third opposing region (s3),
the first region width (wr1) is different from a third region width (wr3) of the third region (r3) in the radial direction, and
the first opposing region width (ws1) is different from a third opposing region width (ws3) of the third opposing region (s3) in the radial direction.

6. The sensor (110) according to claim 5, wherein
the first region width (wr1) is wider than the second region width (wr2),
the first opposing region width (ws1) is narrower than the second opposing region width (ws2),
the first region width (wr1) is wider than the third region width (wr3), and
the first opposing region width (ws1) is narrower than the third opposing region width (ws3).

7. The sensor (110) according to claim 5 or 6, wherein
in a circumferential direction centered on the first center (10C), at least a part of the first region (r1) is provided between the second region (r2) and the third region (r3), and
in the circumferential direction, at least a part of the first opposing region (s1) is provided between the second opposing region (s2) and the third opposing region (s3).

8. The sensor (110) according to claim 1, further comprising:
a second fixed electrode (32A); and
a second opposing fixed electrode (32B),
the movable portion (10M) further including a third annular portion (13),
the second annular portion (12) being provided between the third annular portion (13) and the first annular portion (11),
the second fixed electrode (32A) including a fourth region (r4) and a fifth region (r5),
the second opposing fixed electrode (32B) including a fourth opposing region (s4) and a fifth opposing region (s5),
the fourth region (r4) being provided between the third annular portion (13) and the second annular portion (12),
the fourth opposing region (s4) being provided between the third annular portion (13) and the fourth region (r4),
the fifth region (r5) being provided between the third annular portion (13) and the second annular portion (12),
the fifth opposing region (s5) being provided between the third annular portion (13) and the fifth region (r5),
a fourth region width (wr4) of the fourth region (r4) in the radial direction being different from a fifth region width (wr5) of the fifth region (r5) in the radial direction, and
a fourth opposing region width (ws4) of the fourth opposing region (s4) in the radial direction being different from a fifth opposing region width (ws5) of the fifth opposing region (s5) in the radial direction.

9. The sensor (110) according to claim 8, wherein
the first region width (wr1) is wider than the second region width (wr2),
the first opposing region width (ws1) is narrower than the second opposing region width (ws2),
the fourth region width (wr4) is narrower than the fifth region width (wr5), and
the fourth opposing region width (ws4) is wider than the fifth opposing region width (ws5).

10. The sensor (110) according to claim 8, wherein
the second fixed electrode (32A) further includes a sixth region (r6),
the second opposing fixed electrode (32B) further includes a sixth opposing region (s6),
the sixth region (r6) is provided between the third annular portion (13) and the second annular portion (12),
at least a part of the sixth opposing region (s6) is provided between the third annular portion (13) and the sixth region (r6),
at least a part of the fourth region (r4) is provided between the fifth region (r5) and the sixth region (r6),
the fourth region width (wr4) is different from a sixth region width (wr6) of the sixth region (r6) in the radial direction, and
the fourth opposing region width (ws4) is different from a sixth opposing region width (ws6) of the sixth opposing region (s6) in the radial direction.

11. The sensor (110) according to claim 10, wherein
the first region width (wr1) is wider than the second region width (wr2),
the first opposing region width (ws1) is narrower than the second opposing region width (ws2),
the fourth region width (wr4) is narrower than the fifth region width (wr5),
the fourth opposing region width (ws4) is wider than the fifth opposing region width (ws5),
the fourth region width (wr4) is narrower than the fifth region width (wr5),
the fourth opposing region width (ws4) is wider than the fifth opposing region width (ws5),
the fourth region width (wr4) is narrower than the sixth region width (wr6), and
the fourth opposing region width (ws4) is wider than the sixth opposing region width (ws6).

12. The sensor (110) according to claim 11, wherein
the fifth region (r5) is provided between the fifth opposing region (s5) and the second region (r2), and
the second opposing region (s2) is provided between the fifth region (r5) and the second region (r2).

13. A sensor system, comprising:
the sensor (110) according to any one of claims 1-12; and
a detection target member, the sensor (110) being fixed to the detection target member.

14. An electronic device, comprising:
the sensor (110) according to any one of claims 1-12; and
a circuit controller configured to control a circuit based on a signal obtained from the sensor (110).

## Patentansprüche

1. Sensor (110), aufweisend:
eine Basis (50s) mit einer ersten Fläche (50a);
einen befestigten Abschnitt (10F), der an der ersten Fläche (50a) befestigt ist;
einen bewegbaren Abschnitt (10M), der durch den befestigten Abschnitt (10F) getragen ist;
eine erste befestigte Elektrode (31A), die an der ersten Fläche (50a) befestigt ist; und
eine erste gegenüberliegende, befestigte Elektrode (31B), die an der ersten Fläche (50a) befestigt ist,
wobei ein erster Spalt (G1) zwischen der ersten Fläche (50a) und dem bewegbaren Abschnitt (10M) vorgesehen ist,
wobei der befestigte Abschnitt (10F) eine erste Mitte (10C) in einer ersten Ebene (PL1) parallel zu der ersten Fläche (50a) aufweist,
wobei der bewegbare Abschnitt (10M) einen ersten ringförmigen Abschnitt (11) und einen zweiten ringförmigen Abschnitt (12) aufweist,
wobei der bewegbare Abschnitt (10M) eine Mehrzahl von ersten Verbindungsabschnitten (21) aufweist, die sich entlang der radialen Richtung erstrecken,
die Mehrzahl von ersten Verbindungsabschnitten (21) den ersten ringförmigen Abschnitt (11) und den zweiten ringförmigen Abschnitt (12) verbinden,
die erste befestigte Elektrode (31A) und die erste gegenüberliegende, befestigte Elektrode (31B) zwischen einem der Mehrzahl von ersten Verbindungsabschnitten (21) und einem anderen der Mehrzahl von ersten Verbindungsabschnitten (21) vorgesehen sind, und
der andere der Mehrzahl von ersten Verbindungsabschnitten (21) sich neben dem einen der Mehrzahl von ersten Verbindungsabschnitten (21) befindet, und
**dadurch gekennzeichnet, dass**
die erste befestigte Elektrode (31A) einen ersten Bereich (r1) und einen zweiten Bereich (r2) aufweist,
die erste gegenüberliegende, befestigte Elektrode (31B) einen ersten gegenüberliegenden Bereich (s1) und einen zweiten gegenüberliegenden Bereich (s2) aufweist,
der erste Bereich (r1) zwischen dem zweiten ringförmigen Abschnitt (12) und dem ersten ringförmigen Abschnitt (11) vorgesehen ist,
der erste gegenüberliegende Bereich (s1) zwischen dem zweiten ringförmigen Abschnitt (12) und dem ersten Bereich (r1) vorgesehen ist,
der zweite Bereich (r2) zwischen dem zweiten ringförmigen Abschnitt (12) und dem ersten ringförmigen Abschnitt (11) vorgesehen ist,
der zweite gegenüberliegende Bereich (s2) zwischen dem zweiten ringförmigen Abschnitt (12) und dem zweiten Bereich (r2) vorgesehen ist,
sich eine erste Bereichsbreite (wr1) des ersten Bereichs (r1) in einer radialen Richtung von einer zweiten Bereichsbreite (wr2) des zweiten Bereichs (r2) in der radialen Richtung unterscheidet, wobei die radiale Richtung parallel zu der ersten Ebene (PL1) ist und durch die erste Mitte (10C) verläuft, und
sich eine erste gegenüberliegende Bereichsbreite (ws1) des ersten gegenüberliegenden Bereichs (s1) in der radialen Richtung von einer zweiten gegenüberliegenden Bereichsbreite (ws2) des zweiten gegenüberliegenden Bereichs (s2) in der radialen Richtung unterscheidet.

2. Sensor (110) nach Anspruch 1, wobei
eine von einer ersten Bedingung und einer zweiten Bedingung erfüllt ist,
in der ersten Bedingung die erste Bereichsbreite (wr1) breiter ist als die zweite Bereichsbreite (wr2) und die erste gegenüberliegende Bereichsbreite (ws1) schmaler ist als die zweite gegenüberliegende Bereichsbreite (ws2), und
in der zweiten Bedingung die erste Bereichsbreite (wr1) schmaler ist als die zweite Bereichsbreite (wr2) und die erste gegenüberliegende Bereichsbreite (ws1) breiter ist als die zweite gegenüberliegende Bereichsbreite (ws2).

3. Sensor (110) nach Anspruch 1 oder 2, wobei
sich der zweite Bereich (r2) an den ersten Bereich (r1) anschließt, und
sich der zweite gegenüberliegende Bereich (s2) an den ersten gegenüberliegenden Bereich (s1) anschließt.

4. Sensor (110) nach einem der Ansprüche 1 bis 3, wobei
eine Richtung von dem zweiten gegenüberliegenden Bereich (s2) zu dem ersten Bereich (r1) entlang einer Umfangsrichtung verläuft, die an der ersten Mitte (10C) zentriert ist.

5. Sensor (110) nach Anspruch 1, wobei
die erste befestigte Elektrode (31A) ferner einen dritten Bereich (r3) aufweist,
die erste gegenüberliegende, befestigte Elektrode (31B) ferner einen dritten gegenüberliegenden Bereich (s3) aufweist,
der dritte Bereich (r3) zwischen dem zweiten ringförmigen Abschnitt (12) und dem ersten ringförmigen Abschnitt (11) vorgesehen ist,
zumindest ein Teil des dritten gegenüberliegenden Bereichs (s3) zwischen dem zweiten ringförmigen Abschnitt (12) und dem dritten Bereich (r3) vorgesehen ist,
der erste gegenüberliegende Bereich (s1) zwischen dem zweiten gegenüberliegenden Bereich (s2) und dem dritten gegenüberliegenden Bereich (s3) vorgesehen ist,
sich die erste Bereichsbreite (wr1) von einer dritten Bereichsbreite (wr3) des dritten Bereichs (r3) in der radialen Richtung unterscheidet, und
sich die erste gegenüberliegende Bereichsbreite (ws1) von einer dritten gegenüberliegenden Bereichsbreite (ws3) des dritten gegenüberliegenden Bereichs (s3) in der radialen Richtung unterscheidet.

6. Sensor (110) nach Anspruch 5, wobei
die erste Bereichsbreite (wr1) breiter ist als die zweite Bereichsbreite (wr2),
die erste gegenüberliegende Bereichsbreite (ws1) schmaler ist als die zweite gegenüberliegende Bereichsbreite (ws2),
die erste Bereichsbreite (wr1) breiter ist als die dritte Bereichsbreite (wr3), und
die erste gegenüberliegende Bereichsbreite (ws1) schmaler ist als die dritte gegenüberliegende Bereichsbreite (ws3).

7. Sensor (110) nach Anspruch 5 oder 6, wobei
in einer Umfangsrichtung, die auf der ersten Mitte (10C) zentriert ist, zumindest ein Teil des ersten Bereichs (r1) zwischen dem zweiten Bereich (r2) und dem dritten Bereich (r3) vorgesehen ist, und
in der Umfangsrichtung zumindest ein Teil des ersten gegenüberliegenden Bereichs (s1) zwischen dem zweiten gegenüberliegenden Bereich (s2) und dem dritten gegenüberliegenden Bereich (s3) vorgesehen ist.

8. Sensor (110) nach Anspruch 1, ferner aufweisend:
eine zweite befestigte Elektrode (32A); und
eine zweite gegenüberliegende, befestigte Elektrode (32B),
wobei der bewegbare Abschnitt (10M) ferner einen dritten ringförmigen Abschnitt (13) aufweist,
wobei der zweite ringförmige Abschnitt (12) zwischen dem dritten ringförmigen Abschnitt (13) und dem ersten ringförmigen Abschnitt (11) vorgesehen ist,
wobei die zweite befestigte Elektrode (32A) einen vierten Bereich (r4) und einen fünften Bereich (r5) aufweist,
wobei die zweite gegenüberliegende, befestigte Elektrode (32B) einen vierten gegenüberliegenden Bereich (s4) und einen fünften gegenüberliegenden Bereich (s5) aufweist,
wobei der vierte Bereich (r4) zwischen dem dritten ringförmigen Bereich (13) und dem zweiten ringförmigen Bereich (12) vorgesehen ist,
wobei der vierte gegenüberliegende Bereich (s4) zwischen dem dritten ringförmigen Bereich (13) und dem vierten Bereich (r4) vorgesehen ist,
wobei der fünfte Bereich (r5) zwischen dem dritten ringförmigen Bereich (13 und dem zweiten ringförmigen Bereich (12) vorgesehen ist,
wobei der fünfte gegenüberliegende Bereich (s5) zwischen dem dritten ringförmigen Bereich (13) und dem fünften Bereich (r5) vorgesehen ist,
wobei sich eine vierte Bereichsbreite (wr4) des vierten Bereichs (r4) in der radialen Richtung von einer fünften Bereichsbreite (wr5) des fünften Bereichs (r5) in der radialen Richtung unterscheidet, und
wobei sich eine vierte gegenüberliegende Bereichsbreite (ws4) des vierten gegenüberliegenden Bereichs (s4) in der radialen Richtung von einer fünften gegenüberliegenden Bereichsbreite (ws5) des fünften gegenüberliegenden Bereichs (s5) in der radialen Richtung unterscheidet.

9. Sensor (110) nach Anspruch 8, wobei
die erste Bereichsbreite (wr1) breiter ist als die zweite Bereichsbreite (wr2),
die erste gegenüberliegende Bereichsbreite (ws1) schmaler ist als die zweite gegenüberliegende Bereichsbreite (ws2),
die vierte Bereichsbreite (wr4) schmaler ist als die fünfte Bereichsbreite (wr5), und
die vierte gegenüberliegende Bereichsbreite (ws4) breiter ist als die fünfte gegenüberliegende Bereichsbreite (ws5).

10. Sensor (110) nach Anspruch 8, wobei
die zweite befestigte Elektrode (32A) ferner einen sechsten Bereich (r6) aufweist,
die zweite gegenüberliegende, befestigte Elektrode (32B) ferner einen sechsten gegenüberliegenden Bereich (s6) aufweist,
der sechste Bereich (r6) zwischen dem dritten ringförmigen Abschnitt (13) und dem zweiten ringförmigen Abschnitt (12) vorgesehen ist,
zumindest ein Teil des sechsten gegenüberliegenden Bereichs (s6) zwischen dem dritten ringförmigen Abschnitt (13) und dem sechsten Bereich (r6) vorgesehen ist,
zumindest ein Teil des vierten Bereichs (r4) zwischen dem fünften Bereich (r5) und dem sechsten Bereich (r6) vorgesehen ist,
sich die vierte Bereichsbreite (wr4) von einer sechsten Bereichsbreite (wr6) des sechsten Bereichs (r6) in der radialen Richtung unterscheidet, und
sich die vierte gegenüberliegende Bereichsbreite (ws4) von einer sechsten gegenüberliegenden Bereichsbreite (ws6) des sechsten gegenüberliegenden Bereichs (s6) in der radialen Richtung unterscheidet.

11. Sensor (110) nach Anspruch 10, wobei
die erste Bereichsbreite (wr1) breiter ist als die zweite Bereichsbreite (wr2),
die erste gegenüberliegende Bereichsbreite (ws1) schmaler ist als die zweite gegenüberliegende Bereichsbreite (ws2),
die vierte Bereichsbreite (wr4) schmaler ist als die fünfte Bereichsbreite (wr5),
die vierte gegenüberliegende Bereichsbreite (ws4) breiter ist als die fünfte gegenüberliegende Bereichsbreite (ws5),
die vierte Bereichsbreite (wr4) schmaler ist als die fünfte Bereichsbreite (wr5),
die vierte gegenüberliegende Bereichsbreite (ws4) breiter ist als die fünfte gegenüberliegende Bereichsbreite (ws5),
die vierte Bereichsbreite (wr4) schmaler ist als die sechste Bereichsbreite (wr6), und
die vierte gegenüberliegende Bereichsbreite (ws4) breiter ist als die sechste gegenüberliegende Bereichsbreite (ws6).

12. Sensor (110) nach Anspruch 11, wobei
der fünfte Bereich (r5) zwischen dem fünften gegenüberliegenden Bereich (s5) und dem zweiten Bereich (r2) vorgesehen ist, und
der zweite gegenüberliegende Bereich (s2) zwischen dem fünften Bereich (r5) und dem zweiten Bereich (r2) vorgesehen ist.

13. Sensorsystem, aufweisend:
den Sensor (110) nach einem der Ansprüche 1-12; und
ein Erfassungszielelement, wobei der Sensor (110) an dem Erfassungszielelement befestigt ist.

14. Elektronische Vorrichtung, aufweisend:
den Sensor (110) nach einem der Ansprüche 1-12; und
eine Schaltkreissteuerung, die dazu ausgestaltet ist, einen Schaltkreis basierend auf einem von dem Sensor (110) erhaltenen Signal zu steuern.

## Revendications

1. Capteur (110), comprenant :
une base (50s) incluant une première face (50a) ;
une partie fixe (10F) fixée à la première face (50a) ;
une partie mobile (10M) supportée par la partie fixe (10F) ;
une première électrode fixe (31A) fixée à la première face (50a) ; et
une première électrode fixe opposée (31B) fixée à la première face (50a),
un premier espace (G1) étant disposé entre la première face (50a) et la partie mobile (10M),
la partie fixe (10F) incluant un premier centre (10C) dans un premier plan (PL1) parallèle à la première face (50a),
la partie mobile (10M) incluant une première partie annulaire (11) et une deuxième partie annulaire (12),
dans lequel la partie mobile (10M) inclut une pluralité de premières parties de liaison (21) s'étendant le long de la direction radiale,
la pluralité de premières parties de liaison (21) relient la première partie annulaire (11) et la deuxième partie annulaire (12),
la première électrode fixe (31A) et la première électrode fixe opposée (31B) sont disposées entre l'une parmi la pluralité de premières parties de liaison (21) et une autre parmi la pluralité de premières parties de liaison (21), et
ladite autre parmi la pluralité de premières parties de liaison (21) est à côté de ladite une parmi la pluralité de premières parties de liaison (21), et
**caractérisé en ce que** :
la première électrode fixe (31A) inclut une première région (r1) et une deuxième région (r2),
la première électrode fixe opposée (31B) inclut une première région opposée (s1) et une deuxième région opposée (s2),
la première région (r1) est disposée entre la deuxième partie annulaire (12) et la première partie annulaire (11),
la première région opposée (s1) est disposée entre la deuxième partie annulaire (12) et la première région (r1),
la deuxième région (r2) est disposée entre la deuxième partie annulaire (12) et la première partie annulaire (11),
la deuxième région opposée (s2) est disposée entre la deuxième partie annulaire (12) et la deuxième région (r2),
une première largeur de région (wr1) de la première région (r1) dans une direction radiale est différente d'une deuxième largeur de région (wr2) de la deuxième région (r2) dans la direction radiale, la direction radiale étant parallèle au premier plan (PL1) et passant par le premier centre (10C), et
une première largeur de région opposée (ws1) de la première région opposée (s1) dans la direction radiale est différente d'une deuxième largeur de région opposée (ws2) de la deuxième région opposée (s2) dans la direction radiale.

2. Capteur (110) selon la revendication 1, dans lequel
l'une parmi une première condition et une deuxième condition est satisfaite,
dans la première condition, la première largeur de région (wr1) est plus large que la deuxième largeur de région (wr2), et la première largeur de région opposée (ws1) est plus étroite que la deuxième largeur de région opposée (ws2), et
dans la deuxième condition, la première largeur de région (wr1) est plus étroite que la deuxième largeur de région (wr2), et la première largeur de région opposée (ws1) est plus large que la deuxième largeur de région opposée (ws2).

3. Capteur (110) selon la revendication 1 ou 2, dans lequel
la deuxième région (r2) est continue avec la première région (r1), et
la deuxième région opposée (s2) est continue avec la première région opposée (s1).

4. Capteur (110) selon l'une quelconque des revendications 1 à 3, dans lequel
une direction depuis la deuxième région opposée (s2) vers la première région (r1) est le long d'une direction circonférentielle centrée sur le premier centre (10C).

5. Capteur (110) selon la revendication 1, dans lequel
la première électrode fixe (31A) inclut en outre une troisième région (r3),
la première électrode fixe opposée (31B) inclut en outre une troisième région opposée (s3),
la troisième région (r3) est disposée entre la deuxième partie annulaire (12) et la première partie annulaire (11),
au moins une partie de la troisième région opposée (s3) est disposée entre la deuxième partie annulaire (12) et la troisième région (r3),
la première région opposée (s1) est disposée entre la deuxième région opposée (s2) et la troisième région opposée (s3),
la première largeur de région (wr1) est différente d'une troisième largeur de région (wr3) de la troisième région (r3) dans la direction radiale, et
la première largeur de région opposée (ws1) est différente d'une troisième largeur de région opposée (ws3) de la troisième région opposée (s3) dans la direction radiale.

6. Capteur (110) selon la revendication 5, dans lequel
la première largeur de région (wr1) est plus large que la deuxième largeur de région (wr2),
la première largeur de région opposée (ws1) est plus étroite que la deuxième largeur de région opposée (ws2),
la première largeur de région (wr1) est plus large que la troisième largeur de région (wr3), et
la première largeur de région opposée (ws1) est plus étroite que la troisième largeur de région opposée (ws3).

7. Capteur (110) selon la revendication 5 ou 6, dans lequel
dans une direction circonférentielle centrée sur le premier centre (10C), au moins une partie de la première région (r1) est disposée entre la deuxième région (r2) et la troisième région (r3), et
dans la direction circonférentielle, au moins une partie de la première région opposée (s1) est disposée entre la deuxième région opposée (s2) et la troisième région opposée (s3).

8. Capteur (110) selon la revendication 1, comprenant en outre :
une deuxième électrode fixe (32A) ; et
une deuxième électrode fixe opposée (32B),
la partie mobile (10M) incluant en outre une troisième partie annulaire (13),
la deuxième partie annulaire (12) étant disposée entre la troisième partie annulaire (13) et la première partie annulaire (11),
la deuxième électrode fixe (32A) incluant une quatrième région (r4) et une cinquième région (r5),
la deuxième électrode fixe opposée (32B) incluant une quatrième région opposée (s4) et une cinquième région opposée (s5),
la quatrième région (r4) étant disposée entre la troisième partie annulaire (13) et la deuxième partie annulaire (12),
la quatrième région opposée (s4) étant disposée entre la troisième partie annulaire (13) et la quatrième région (r4),
la cinquième région (r5) étant disposée entre la troisième partie annulaire (13) et la deuxième partie annulaire (12),
la cinquième région opposée (s5) étant disposée entre la troisième partie annulaire (13) et la cinquième région (r5),
une quatrième largeur de région (wr4) de la quatrième région (r4) dans la direction radiale étant différente d'une cinquième largeur de région (wr5) de la cinquième région (r5) dans la direction radiale, et
une quatrième largeur de région opposée (ws4) de la quatrième région opposée (s4) dans la direction radiale étant différente d'une cinquième largeur de région opposée (ws5) de la cinquième région opposée (s5) dans la direction radiale.

9. Capteur (110) selon la revendication 8, dans lequel
la première largeur de région (wr1) est plus large que la deuxième largeur de région (wr2),
la première largeur de région opposée (ws1) est plus étroite que la deuxième largeur de région opposée (ws2),
la quatrième largeur de région (wr4) est plus étroite que la cinquième largeur de région (wr5), et
la quatrième largeur de région opposée (ws4) est plus large que la cinquième largeur de région opposée (ws5).

10. Capteur (110) selon la revendication 8, dans lequel
la deuxième électrode fixe (32A) inclut en outre une sixième région (r6),
la deuxième électrode fixe opposée (32B) inclut en outre une sixième région opposée (s6),
la sixième région (r6) est disposée entre la troisième partie annulaire (13) et la deuxième partie annulaire (12),
au moins une partie de la sixième région opposée (s6) est disposée entre la troisième partie annulaire (13) et la sixième région (r6),
au moins une partie de la quatrième région (r4) est disposée entre la cinquième région (r5) et la sixième région (r6),
la quatrième largeur de région (wr4) est différente d'une sixième largeur de région (wr6) de la sixième région (r6) dans la direction radiale, et
la quatrième largeur de région opposée (ws4) est différente d'une sixième largeur de région opposée (ws6) de la sixième région opposée (s6) dans la direction radiale.

11. Capteur (110) selon la revendication 10, dans lequel
la première largeur de région (wr1) est plus large que la deuxième largeur de région (wr2),
la première largeur de région opposée (ws1) est plus étroite que la deuxième largeur de région opposée (ws2),
la quatrième largeur de région (wr4) est plus étroite que la cinquième largeur de région (wr5),
la quatrième largeur de région opposée (ws4) est plus large que la cinquième largeur de région opposée (ws5),
la quatrième largeur de région (wr4) est plus étroite que la cinquième largeur de région (wr5),
la quatrième largeur de région opposée (ws4) est plus large que la cinquième largeur de région opposée (ws5),
la quatrième largeur de région (wr4) est plus étroite que la sixième largeur de région (wr6), et
la quatrième largeur de région opposée (ws4) est plus large que la sixième largeur de région opposée (ws6).

12. Capteur (110) selon la revendication 11, dans lequel
la cinquième région (r5) est disposée entre la cinquième région opposée (s5) et la deuxième région (r2), et
la deuxième région opposée (s2) est disposée entre la cinquième région (r5) et la deuxième région (r2).

13. Système de capteur, comprenant :
le capteur (110) selon l'une quelconque des revendications 1 à 12 ; et
un organe cible de détection, le capteur (110) étant fixé à l'organe cible de détection.

14. Dispositif électronique, comprenant :
le capteur (110) selon l'une quelconque des revendications 1 à 12 ; et
un dispositif de commande de circuit configuré pour commander un circuit sur la base d'un signal obtenu en provenance du capteur (110).
